(19) Europäisches Patentamt
European Patent Office
Office européen des brevets

(11) Veröffentlichungsnummer : **0 035 715**
**B1**

(12) # EUROPÄISCHE PATENTSCHRIFT

(45) Veröffentlichungstag der Patentschrift : **18.01.84**

(51) Int. Cl.³ : **H 01 B 1/12**

(21) Anmeldenummer : **81101423.2**

(22) Anmeldetag : **27.02.81**

(54) **Verfahren zur Herstellung elektrisch leitfähiger Heteropolyaromaten und deren Verwendung in der Elektrotechnik und zur antistatischen Ausrüstung von Kunststoffen.**

(30) Priorität : **12.03.80 DE 3009350**

(43) Veröffentlichungstag der Anmeldung : **16.09.81 Patentblatt 81/37**

(45) Bekanntmachung des Hinweises auf die Patenterteilung : **18.01.84 Patentblatt 84/03**

(84) Benannte Vertragsstaaten : **AT BE CH DE FR GB LI NL**

(56) Entgegenhaltungen :
**EP-A- 0 016 305**
**EP-A- 0 023 596**
**EP-A- 0 031 444**
**EP-A- 0 031 967**
**DE-B- 1 178 529**
**JOURNAL OF THE CHEMICAL SOCIETY, CHEM. COMM., Nr. 8, 6. Mai 1980, Seiten 347-348 J.F. RABOLT et al.: "Organic metals: Poly-(p-phenyle sulphide) Hexafluoroarsenate"**
**JOURNAL OF CHEMICAL PHYSICS, Band 71, Nr. 3, 1. August 1979, Seiten 1506-1507 D.M. IVORY et al.: "Highly conducting charge-transfer complexes of poly(p-phenylene)"**

(73) Patentinhaber : **BASF Aktiengesellschaft**
**Carl-Bosch-Strasse 38**
**D-6700 Ludwigshafen (DE)**

(72) Erfinder : **Blinne, Gerd, Dr.**
**Im Woogtal 7**
**D-6719 Bobenheim (DE)**
Erfinder : **Naarmann, Herbert, Dr.**
**Haardtblick 15**
**D-6719 Wattenheim (DE)**
Erfinder : **Penzien, Klaus, Dr.**
**Bensheimer Ring 18**
**D-6710 Frankenthal (DE)**

**EP 0 035 715 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

Verfahren zur Herstellung elektrisch leitfähiger Heteropolyaromaten und deren Verwendung in der Elektrotechnik und zur antistatischen Ausrüstung von Kunststoffen

Die Erfindung betrifft ein Verfahren zur Herstellung von elektrisch leitfähigen Heteropolyaromaten mit elektrischen Leitfähigkeitswerten größer als $10^{-2}$S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bekannt, Polyphenylene durch oxidative Kupplung entsprechend der Literatur: « Macromolecular Syntheses Collective », Vol. 1, (1977) Seiten 109 bis 110, und « Naturwissenschaften » 56 (1969) Seiten 308 bis 313 herzustellen. Außerdem ist die Herstellung von Polyphenylenen durch stufenweise Polykondensation nach R. Gehm und W. Kern aus « Makromolekulare Chemie » *7* (1951) Seiten 46 bis 61 bekannt, wobei besonders einheitliche para-verkettete methylsubstituierte Derivate erhalten werden, die nicht zusätzlich durch ortho- oder meta-verknüpfte Polymere verunreinigt sind.

Heteropolyaromaten unterscheiden sich von den Polyaromaten durch das Vorhandensein von Heteroatomen oder Heteroatome enthaltenden Gruppen im Molekül neben den aromatischen Ringsystemen. Heteropolyaromaten, die mindestens 2 Phenylengruppen oder kondensierte Systeme zwischen den Heteroatomen bzw. den Heteroatome enthaltenden Gruppen aufweisen, können beispielsweise analog der Vorschrift in « Macromolecular Syntheses » Vol. 6, (1978), 45-48 und DE-PS 1 468 782 hergestellt werden.

Der Erfindung lag die Aufgabe zugrunde, ein Verfahren zur Herstellung von elektrisch leitfähigen Heteropolyaromaten mit elektrischen Leitfähigkeitswerten größer als $10^{-2}$S/cm aufzuzeigen.

Diese Aufgabe wird erfindungsgemäß dadurch gelöst, daß man Heteropolyaromaten der allgemeinen Formel (I)

$$[K - X]_m \qquad (I)$$

worin

K = ein mindestens dreikerniges kondensiertes aromatisches Ringsystem, wie Anthracen, Perylen oder Coronen ;

X = S, O, $SO_2$, NH, Se oder

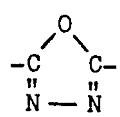

und

m = 1 bis 5, vorzugsweise 1-2 ;

bedeuten, unter Ausschluß von Wasserfeuchtigkeit und von Sauerstoff 0,5 bis 35 Gewichtsprozent, bezogen auf den eingesetzten Heteropolyaromaten, einer starken Lewis-Säure mit einem $pk_s$-Wert von $-10$ bis $+4$ zusetzt.

Nach bevorzugter Verfahrensweise wird als Lewis-Säure $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt.

Die Herstellung der Heteropolyaromaten kann nach der eingangs zitierten Literatur erfolgen. Gegebenfalls können auch verschiedene Heteroatome oder Heteroatome enthaltende Gruppen in einem Molekül vorkommen.

Die elektrischen Leitfähigkeitswerte werden in S/cm bei 30 °C gemessen, die Messung selbst erfolgt nach der Methode von F. Beck, Berichte Bunsengesellschaft, Physikalische Chemie *68* (1964) Seiten 558 bis 567. Die Leitfähigkeitswerte der erfindungsgemäß hergestellten, elektrisch leitfähigen Heteropolyaromaten sind größer als $10^{-2}$S/cm.

Nach dem erfindungsgemäßen Verfahren werden den Heteropolyaromaten der Formel (I) unter Ausschluß von Wasserfeuchtigkeit und von Sauerstoff 0,5 bis 35 Gewichtsprozent, bezogen auf den eingesetzten Heteropolyaromaten, einer starken Lewis-Säure mit einem $pK_s$-Wert von $-10$ bis $+4$ zugesetzt. Vorzugsweise wird unter Edelgas (Argon) -atmosphäre gearbeitet. Gegebenenfalls werden Hilfsflüssigkeiten wie Tetrahydrofuran, Dimethoxyglykol. Nitromethan oder Methylenchlorid eingesetzt, die nach dem Einarbeiten der Lewis-Säuren bei Temperaturen unter 30 °C im Vakuum abgezogen werden.

Durch die genannten Zusätze können Anstiege in der elektrischen Leitfähigkeit von einigen Größenordnungen erreicht werden. Die Ausgangsleitfähigkeiten der Heteropolyaromaten liegen im allgemeinen unter $10^{-12}$S/cm. Nach der Zugabe der Lewis-Säuren werden jedoch elektrische Leitfähigkeiten größer als $10^{-2}$S/cm erzielt.

Die erfindungsgemäß hergestellten elektrisch leitfähigen Heteropolyaromaten mit elektrischen Leitfähigkeiten größer als $10^{-2}$S/cm sind zur antistatischen Ausrüstung von Kunststoffen, zur Herstellung von Sonnenzellen, zur Umwandlung und Fixierung von Strahlung sowie zur Herstellung elektrischer und

magnetischer Schalter geeignet. Durch die Zusätze der starken Lewis-Säure zu den Heteropolyaromaten entstehen sog. p-Leiter (vgl. J. Chem. Education, Vol. *46*, Nr. 2, Seite 82 (1969)).

Die in den folgenden Beispielen genannten Teile sind, soweit nicht anders angegeben, Gewichtsteile. Die Bestimmung des Molgewichts erfolgt z. B. über die Intrinsic Viskosität dl/g $CHCl_3$ bei 25 °C (Lit. A.S. Hay, Macromolecular Syntheses Coll. Vol. 1, Seite 83 (1977).

Beispiele 1-3

10 Teile eines Heteropolyaromaten werden unter Argonatmosphäre und Ausschluß von Feuchtigkeit mit dem jeweiligen Zusatzstoff versetzt. Die Messung der elektrischen Leitfähigkeit erfolgt nach F. Beck, Ber. Bunsengesellschaft, Phys. Chem. *68*, 558-567 (1964).

| Beispiel Nr. | $[K-X]_m$ | m | X | Molgewicht | Zusatzstoff Art und Menge in Mol % | | Leitfähigkeit S/cm 30 °C vor dem Zusatz | Leitfähigkeit S/cm 30 °C nach dem Zusatz |
|---|---|---|---|---|---|---|---|---|
| 1 | 10 Teile K = Anthracen | 2 | S | ca. 500 | $AsF_5$ | 0,2 | $< 10^{-12}$ | $3{,}9 \cdot 10^{-1}$ |
| 2 | 10 Teile K = Perylen | 2 | S | ca. 550 | $AsF_5$ | 0,2 | $< 10^{-12}$ | $5{,}8 \cdot 10^{-1}$ |
| 3 | 10 Teile K = Coronen | 2 | S | ca. 600 | $AsF_5$ | 0,2 | $< 10^{-12}$ | $2{,}1 \cdot 10^{+2}$ |

**Ansprüche**

1. Verfahren zur Herstellung von elektrisch leitfähigen Heteropolyaromaten mit elektrischen Leitfähigkeitswerten größer als $10^{-2}$S/cm, bei dem Heteropolyaromaten unter Ausschluß von Wasserfeuchtigkeit und von Sauerstoff 0,5 bis 35 Gewichtsprozent, bezogen auf den eingesetzten Heteropolyaromaten, einer starken Lewis-Säure mit einem $pk_s$-Wert von $-10$ bis $+4$ zugesetzt werden, dadurch gekennzeichnet, daß Heteropolyaromaten der allgemeinen Formel (I)

$$[K-X]_m \qquad (I)$$

eingesetzt werden, worin

K = ein mindestens dreikerniges kondensiertes aromatisches Ringsystems ;

X = S, O, $SO_2$, NH, Se oder

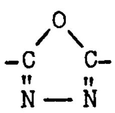

und

m = 1 bis 5 bedeuten.

2. Verfahren nach Anspruch 1, dadurch gekennzeichnet, daß in der Formel (I) K = Anthracen, Perylen oder Coronen ist.

3. Verfahren nach den Ansprüchen 1 und 2, dadurch gekennzeichnet, daß als Lewis-Säure $AsF_5$, $SbF_5$, $UF_6$, $HClO_4$, $NO^+SbF_6^-$, $NO_2^+SbF_6^-$, $NO^+AsF_6^-$, $NO^+PF_6$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt wird.

4. Verwendung der nach einem der Ansprüche 1 bis 3 hergestellten, elektrisch leitfähigen Heteropolyaromaten in der Elektrotechnik zur Herstellung von Sonnenzellen, zur Umwandlung und Fixierung von Strahlung und zur Herstellung elektrischer und magnetischer Schalter.

5. Verwendung der nach einem der Ansprüche 1 bis 3 hergestellten, elektrisch leitfähigen Heteropolyaromaten zur antistatischen Ausrüstung von Kunststoffen.

**Claims**

1. A process for the preparation of electrically conductive hetero-polyaromatics having electrical conductivities greater than $10^{-2}$S/cm, from 0.5 to 35 per cent by weight, based on the hetero-polyaromatic employed, of a strong Lewis acid having a $pk_a$ of from $-10$ to $+4$ being added to the hetero-polyaromatic in the absence of moisture and of oxygen, wherein there are used hetero-polyaromatics of the general formula (I)

$$[K-X]_m \qquad (I)$$

where

K is an at least trinuclear fused aromatic ring system,

X is S, O, $SO_2$, NH, Se or

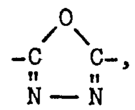

and

m is from 1 to 5.

2. A process as claimed in claim 1, wherein in the formula (I) K is anthracene, perylene or coronene.

3. A process as claimed in claims 1 and 2, wherein the Lewis acid used is $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-trinitrophenol, 2,4,6-trinitrophenylsulfonic acid or 2,4,6-trinitro-benzoic acid.

4. The use of the electrically conductive hetero-polyaromatics, prepared as claimed in any of claims 1 to 3, in electrical engineering for the production of solar cells, for the conversion and fixing of radiation, and for the production of electrical and magnetic switches.

5. The use of the electrically conductive hetero-polyaromatics, prepared as claimed in any of claims 1 to 3, for the antistatic finishing of plastics materials.

**Revendications**

1. Procédé pour la préparation de carbures hétéropolyaromatiques électriquement conducteurs, ayant des valeurs de conductibilité électrique de plus de $10^{-2}$ S/cm, procédé dans lequel il est ajouté au carbure hétéropolyaromatique, en l'absence d'humidité aqueuse et d'oxygène, 0,5 à 35 % en poids, par rapport au carbure hétéropolyaromatique utilisé, d'un acide de Lewis fort ayant un $pK_s$ de $-10$ à $+4$, caractérisé en ce que l'on utilise des carbures hétéropolyaromatiques de formule générale (I)

$$[K - X]_m \qquad (I)$$

dans laquelle

K = Système condensé de noyaux aromatiques à trois noyaux au moins ;

X = S, O, $SO_2$, NH, Se ou

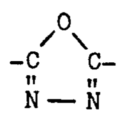

et

m = 1 à 5.

2. Procédé selon la revendication 1, caractérisé en ce que dans la formule (I), K est un anthracène, un pérylène ou un coronène.

3. Procédé selon la revendication 1 et 2, caractérisé en ce qu'il est ajouté, en tant qu'acide de Lewis, $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, du 2,4,6-trinitrophénol, de l'acide 2,4,6-trinitrophénylsulfonique ou de l'acide 2,4,6-trinitrobenzoïque.

4. Utilisation des carbures hétéropolyaromatiques électriquement conducteurs, préparés suivant l'une quelconque des revendications 1 à 3, dans l'électrotechnique pour la fabrication de piles solaires, pour la conversion et la fixation de rayonnements et pour la fabrication de commutateurs électriques et magnétiques.

5. Utilisation des carbures hétéropolyaromatiques électriquement conducteurs, préparés suivant l'une quelconque des revendications 1 à 3, pour le traitement antistatique de matières synthétiques.